# EUROPEAN PATENT APPLICATION

(11) **EP 2 302 689 A1**
(43) Date of publication of application: **30.03.2011**
(21) Application number: 08790844.8
(22) Date of filing: 03.07.2008
(51) Int. Cl.: H01L 31/0224, H01L 31/068

(54) **PHOTOVOLTAIC SYSTEM AND MANUFACTURING METHOD THEREOF**

(71) Applicant: Mitsubishi Electric Corporation, Tokyo 100-8310 (JP)
(72) Inventor: MIZUGUCHI, Kazuo, Tokyo 100-8310 (JP); MORIKAWA, Hiroaki, Tokyo 100-8310 (JP)
(74) Representative: Pfenning, Meinig & Partner GbR
(86) International application number: PCT/JP2008/062100
(87) International publication number: WO 2010/001473

(57) **Abstract**

A photovoltaic device that can make a width of a surface electrode formed under high speed annealing condition be equal to a width of a conventional surface electrode that is not formed under high speed annealing condition; is obtained. The photovoltaic device is constituted by a p-type silicon substrate 101; an n-type diffusion layer 102 formed on a light incident surface side of the p-type silicon substrate 101; a surface electrode 110 formed on the n-type diffusion layer 102; a p+ layer 103 formed on a rear surface of the p-type silicon substrate 101 opposing the light incident surface; and a rear surface electrode 120 formed at a predetermined position on the p+ layer 103. The surface electrode 110 includes a first electrode layer 111 formed on the n-type diffusion layer 102; and a second electrode layer 112 that includes one or more layers, is formed on the first electrode layer 111, and has a smaller specific resistance than that of the first electrode layer 111.

## Description

### TECHNICAL FIELD

The present invention relates to a photovoltaic device and a manufacturing method thereof.

### BACKGROUND ART

At present, silicon solar cells are mainly used on the earth as power solar cells, and a manufacturing method thereof in mass production is generally simplified as possible to reduce manufacturing costs. An example of the manufacturing method in mass production is described here (see, for example, Patent Document 1). Phosphorus (P) is thermally diffused on an entire surface of a p-type silicon substrate to form an n-type diffusion layer. Then etching is performed to leave the n-type diffusion layer only on one main surface. A silicon nitride film is formed on the n-type diffusion layer as a reflection preventing film by a plasma CVD (Chemical Vapor Deposition) method. Then an aluminum paste and a silver paste for a rear surface are screen printed on a rear surface of the silicon substrate and dried successively. A silver paste for a surface that becomes a surface electrode is screen printed on the silicon nitride film and dried. In general, a surface electrode is formed by printing once in most silicon solar cells. However, in Patent Document 1, in order to reduce costs and prevent waste consumption of resources, at the time of forming a surface electrode that has a comb-type electrode structure including a grid electrode and a bus electrode, a silver paste is printed in a first time by using a mask pattern of the grid electrode and the bus electrode and dried, and then a silver paste is printed on the silver paste of the grid electrode by the first printing, by using a mask pattern of the grid electrode and dried. A resultant device is annealed in a near infrared furnace for several minutes to ten odd minutes with an annealing profile in which a peak temperature is 700 to 900°C. As a result, on a rear surface side, a p+ layer that contains aluminum as an impurity with high density, a rear surface aluminum electrode, and a rear surface silver electrode are formed. On a surface side, a silver paste for a surface melts and penetrates the silicon nitride film during annealing, so that a surface silver electrode that can electrically contact the n-type diffusion layer is formed. In this way, the silicon solar cell is manufactured. Incidentally, for metal pastes used for forming these surface and rear surface electrodes, a thick film paste composition prepared by dispersing metal powder and glass powder serving as main components in an organic vehicle is used. The glass powder contained in the metal paste reacts with and adheres to a silicon surface on the surface and the rear surface, so that a mechanical strength of electrodes is held.

Recently, to achieve high efficiency of the solar cell, it is described that an annealing time required for annealing electrodes is reduced to suppress a deterioration in the crystal quality. For example, it is known that a diffusion length (a life time) that is one of indexes of high efficient solar cells can be improved depending on an annealed state (see, for example, Nonpatent Literature 1). Specifically, it is described that as the annealing time is reduced, the life time is improved.

Patent Document 1: Pamphlet of International Publication No. WO 2005/109524
Nonpatent Literature 1: Ajeet Rohatgi, "Designs and Fabrication Technologies for Future Commercial Crystalline Si Solar Cells", 15th Proc. Workshop on Crystalline Silicon Solar Cells and Modules, Materials and Processes (Colorado), 2005, P.11

### DISCLOSURE OF INVENTION

### PROBLEM TO BE SOLVED BY THE INVENTION

As described in Nonpatent Literature 1; however, as the electrode annealing time is reduced, the surface electrode is difficult to melt and penetrate the reflection preventing film to electrically contact the n-type diffusion layer. Further, because a reaction time as the surface silver electrode is reduced, conductivity becomes inferior. When the surface electrode is formed under a high-speed annealing condition, a silver paste that can melt and penetrate the reflection preventing film under a high-speed annealing condition to contact the n-type diffusion layer must be selected. However, such a silver paste that can melt and penetrate the reflection preventing film in a short time must have a large width as compared to a case that the surface electrode is not formed under a high-speed annealing condition, because a specific resistance of a silver electrode after annealing is high. As a result, it is made difficult to achieve high efficiency due to increasing an aperture ratio of a surface by reducing a ratio in which the surface electrode covers a silicon substrate by making the electrode thin.

The present invention has been achieved in view of the above problems, and an object of the present invention is to provide a photovoltaic device that can increase an aperture ratio to a substrate even when a surface electrode is formed under a high-speed annealing condition and to provide a manufacturing method thereof.

### MEANS FOR SOLVING PROBLEM

In order to solve the aforementioned problems and attain the aforementioned object, a photovoltaic device according to one aspect of the present invention is constructed in such manner as to have a semiconductor substrate of a first conductive type; a first diffusion layer that an impurity of a second conductive type is diffused in a light incident surface side of the semiconductor substrate; a surface electrode formed on the first diffusion layer; a second diffusion layer of the first conductive type formed on a rear surface of the semiconductor substrate opposing the light incident surface; and a rear surface electrode formed at a predetermined position on the second diffusion layer, wherein the surface electrode comprising: a first electrode layer formed on the first diffusion layer; and a second electrode layer that is formed on the first electrode layer, has a smaller specific resistance than that of the first electrode layer, and includes one or more layers.

### EFFECT OF THE INVENTION

According to the present invention, the first electrode layer is placed on the first diffusion layer, and the second electrode layer with a small resistivity is placed on the first electrode layer, and thus, even when a specific resistance of the first electrode layer is large, the electrode can be made thin even in high speed annealing. Furthermore, an area of the electrode on a surface side is reduced to increase an aperture ratio and high efficiency is realized, without reducing the quality of crystals.

### BRIEF DESCRIPTION OF DRAWINGS

FIG. 1 is a top view of a configuration of a photovoltaic device according to a first embodiment of the present invention.
FIG. 2 is a cross-sectional view along a line A-A shown in FIG. 1.
FIG. 3-1 is a schematic cross-sectional view of an example of a process procedure of a manufacturing method of the photovoltaic device according to the first embodiment (part 1).
FIG. 3-2 is a schematic cross-sectional view of an example of a process procedure of the manufacturing method of the photovoltaic device according to the first embodiment (part 2).
FIG. 3-3 is a schematic cross-sectional view of an example of a process procedure of the manufacturing method of the photovoltaic device according to the first embodiment (part 3).

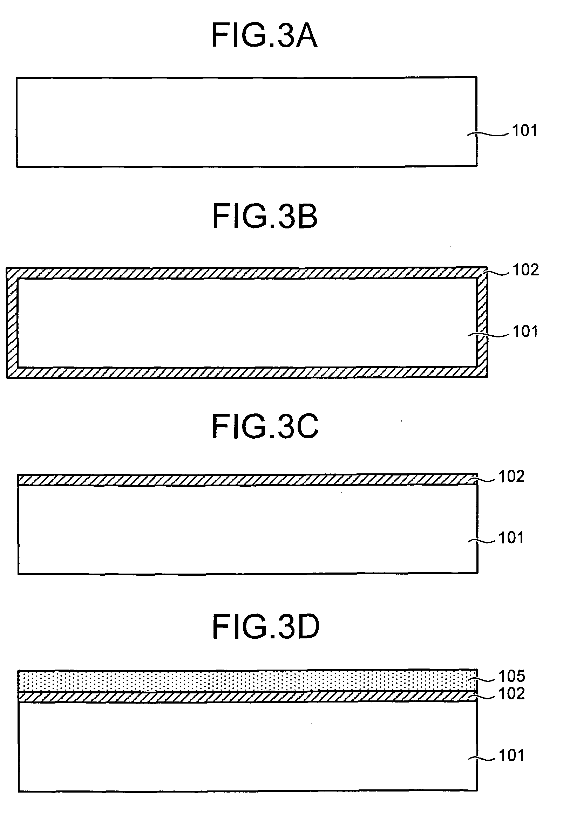

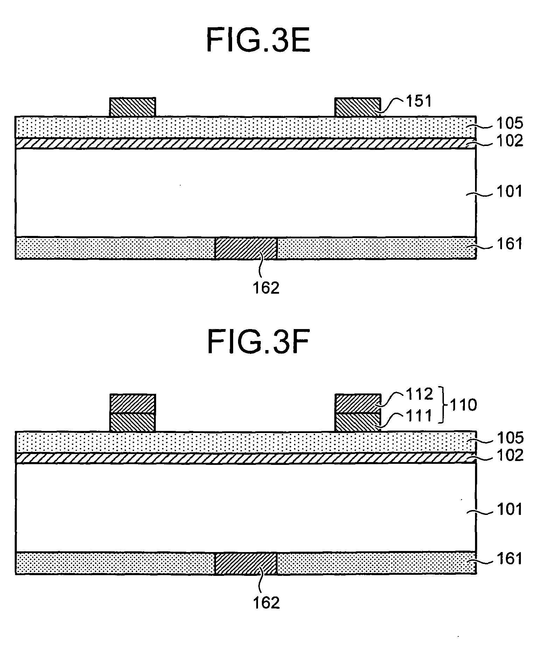

FIG. 3-4 is a schematic cross-sectional view of an example of a process procedure of the manufacturing method of the photovoltaic device according to the first embodiment (part 4).
FIG. 3-5 is a schematic cross-sectional view of an example of a process procedure of the manufacturing method of the photovoltaic device according to the first embodiment (part 5).
FIG. 3-6 is a schematic cross-sectional view of an example of a process procedure of the manufacturing method of the photovoltaic device according to the first embodiment (part 6).

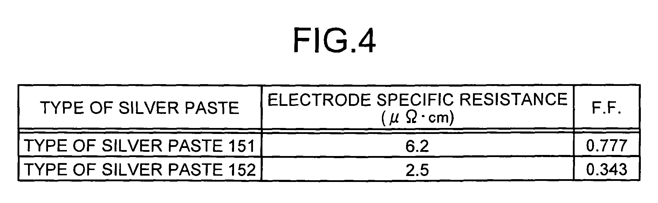

FIG. 4 is an example of characteristics of silver pastes used for forming a surface electrode.

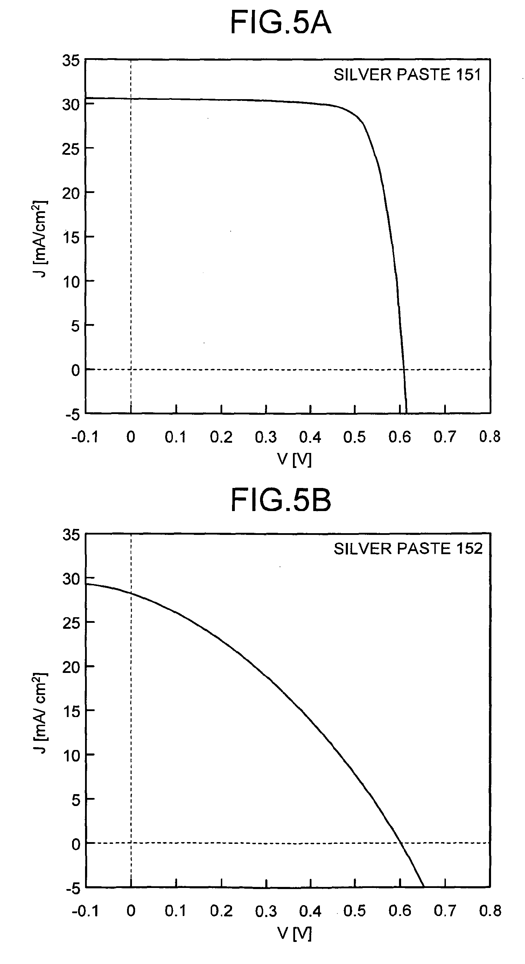

FIG. 5-1 depicts a fill factor of a photovoltaic device when a silver paste 151 is used.
FIG. 5-2 depicts a fill factor of a photovoltaic device when a silver paste 152 is used.

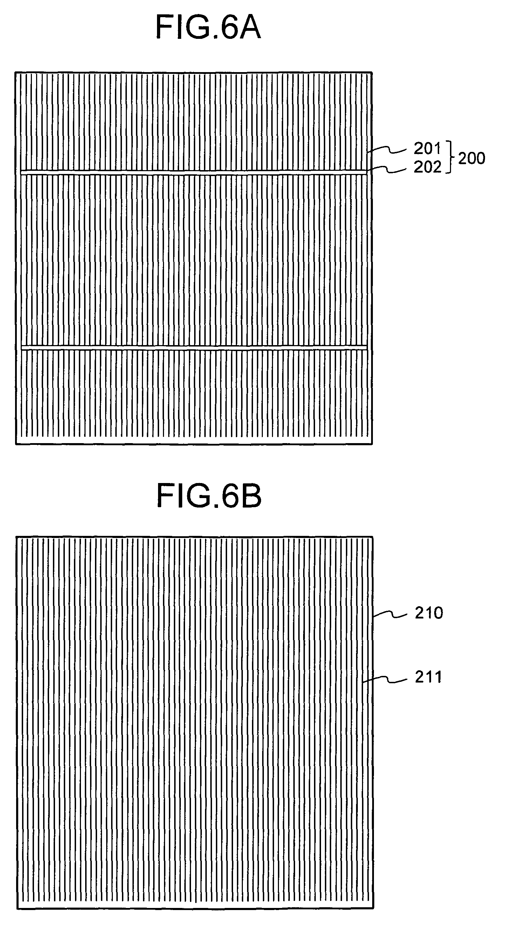

FIG. 6-1 is an example of a top view of a mask pattern used for printing a first electrode layer.
FIG. 6-2 is an example of a top view of a mask pattern used for printing a second electrode layer.

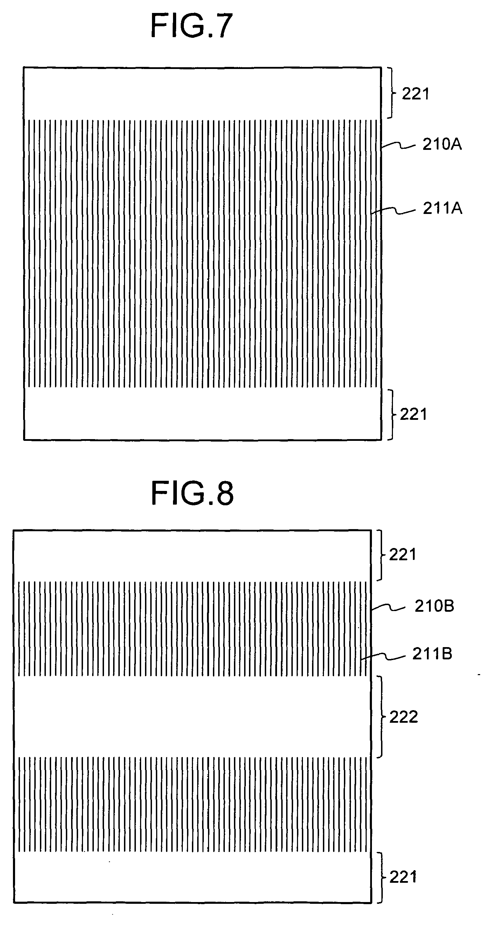

FIG. 7 is an example of a mask pattern used in a second embodiment of the present invention.
FIG. 8 is another example of a mask pattern used in the second embodiment of the present invention.

### EXPLANATIONS OF LETTERS OR NUMERALS

- 100: Photovoltaic device
- 101: p-type silicon substrate
- 102: n-type diffusion layer
- 103: p+ layer
- 105: Reflection preventing film
- 110: Surface electrode
- 111: First electrode layer
- 112: Second electrode layer
- 120: Rear surface electrode
- 121: Rear-surface collecting electrode
- 122: Rear-surface lead-out electrode
- 131: Grid electrode
- 132: Bus electrode
- 151,: 152 Silver paste
- 161: Aluminum paste
- 162: Silver paste for rear surface
- 200,: 210, 210A, 210B Mask pattern
- 201,: 211, 211A, 211B Grid-electrode forming portion
- 202: Bus-electrode forming portion
- 221: Ends in extending direction of grid electrode
- 222: Central portion in extending direction of grid electrode

### BEST MODE(S) FOR CARRYING OUT THE INVENTION

Exemplary embodiments of a manufacturing method of a photovoltaic device according to the present invention will be explained below in detail with reference to the accompanying drawings. The present invention is not limited to the embodiments. In addition, cross-sectional views of a photovoltaic device explained in the following embodiments are only schematic, and the relationship between thickness and width, the ratio of thickness of each layer or the like shown in the drawings are different from actual products.

### First Embodiment.

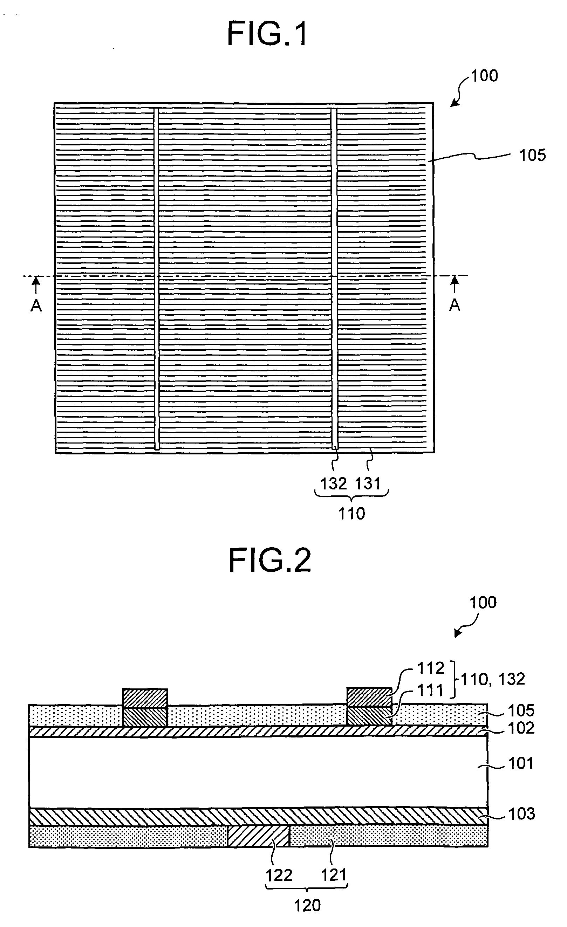

FIG. 1 is a top view of a construction of a photovoltaic device according to a first embodiment of the invention, and FIG. 2 is a cross-sectional view along a line A-A shown in FIG. 1. A photovoltaic device 100 is provided with a photoelectric conversion layer that includes a p-type silicon substrate 101 serving as a semiconductor substrate, an n-type diffusion layer 102 obtained by diffusing an n-type impurity on one main surface side (a light receiving surface side) of the p-type silicon substrate 101, and a p+ layer 103 that contains a p-type impurity with higher density than that of the p-type silicon substrate 101 on the other main surface side (rear side) of the p-type silicon substrate 101.

A rear-surface collecting electrode 121 made of aluminum and provided on a substantially entire surface of the p+ layer 103 for both collecting electricity generated in the photoelectric conversion layer and reflecting incident light that has transmitted the photoelectric conversion layer; and a rear-surface lead-out electrode 122 made of silver for taking out electricity generated in the rear-surface collecting electrode 121, are formed as a rear surface electrode 120 on a rear surface side (the side of the p+ layer 103) of the photoelectric conversion layer. Most of the rear surface electrode 120 is occupied by the rear-surface collecting electrode 121 made of aluminum because it is necessary to form the p+ layer 103. However the rear-surface collecting electrode 121 (aluminum) cannot be soldered. Therefore the rear-surface lead-out electrode 122 is formed at a part of the rear surface as an electrode made of a copper foil for connecting photovoltaic devices.

A reflection preventing film 105 for preventing reflection of incident light that enters the light receiving surface of the photoelectric conversion layer; and a surface electrode 110 that is provided with both a grid electrode 131 made of silver and provided on the light receiving surface for locally collecting the electricity generated in the photoelectric conversion layer and a bus electrode 132 made of silver and provided to be substantially perpendicular to the grid electrode 131 for taking out electricity collected in the grid electrode 131; are provided on a light receiving surface side (i.e., the side of the n-type diffusion layer 102) of the photoelectric conversion layer.

The surface electrode 110 has a multi-layer structure that is constituted by a plurality of layers with different characteristics. According to this example, the surface electrode 110 is constituted by a first electrode layer 111 that is formed to contact the n-type diffusion layer 102 and made of silver with an excellent electrical contact characteristic with the n-type diffusion layer 102; and a second electrode layer 112 on the first electrode layer 111 made of silver with a smaller specific resistance than that of the first electrode layer 111. While the grid electrode 131 with any width can be formed, the grid electrode 131 desirably has a width of 0.15 millimeter or smaller, particularly 0.1 millimeter or smaller. By using the thin grid electrode 131, an area of the surface electrode 110 can be reduced and an aperture ratio can be increased. Generally, when the width of the grid electrode 131 is reduced and a cross section of the grid electrode 131 is smaller than that of a cross section of a conventional grid electrode, its resistance is increased. However, by forming the multi-layer structure with a material having a small specific resistance at the upper layer, the resistance of the grid electrode 131 can be equal to or lower than the resistance in the case that the conventional wide grid electrode is used.

According to the photovoltaic device 100 with such a construction, when sunlight is irradiated from the light receiving surface side of the photovoltaic device 100 onto a pn junction surface (a junction surface of the p-type silicon substrate 101 and the n-type diffusion layer 102), holes and electrons are generated. By an electric field near the pn junction surface, the generated electrons move toward the n-type diffusion layer 102 and the holes move toward the p+ layer 103. By this, excessive electrons exist in the n-type diffusion layer 102 and excessive holes exist in the p+ layer 103. As a result, a photovoltaic force or Photovoltaic is generated. This photovoltaic force is generated in a direction to bias the pn junction in a forward direction. The surface electrode 110 connected to the n-type diffusion layer 102 becomes a negative pole and the rear surface electrode 120 connected to the p+ layer 103 becomes a positive pole, and thus a current flows in an external circuit (not shown). Incidentally, on the light receiving surface side, the generated electrons pass through the n-type diffusion layer 102 to be collected by the grid electrode 131 and then the bus electrode 132. At this time, in the grid electrode 131, the first electrode layer 111 that contacts the n-type diffusion layer 102 has an excellent electrical contact characteristic with the n-type diffusion layer 102 and thus takes in electrons while suppressing losses. The electrons pass through the second electrode layer 112 with a lower specific resistance than that of the first electrode layer 111 to reach the bus electrode 132. The bus electrode 132 also takes in the electrons at the first electrode layer 111 like the grid electrode 131 and combines the resultant electrons with the electrons collected by the grid electrode 131 to flow them from the second electrode layer 112 to the external circuit with a low resistance. Outputs are thus taken out toward the external circuit.

A manufacturing method of the photovoltaic device 100 with the above construction is descried next. FIGS. 3-1 to 3-6 are schematic cross-sectional views of an example of a process procedure of a manufacturing method of the photovoltaic device according to the first embodiment.

The p-type silicon substrate 101 is prepared at first (FIG. 3-1). The n-type diffusion layer 102 whose conductive type is inverted by thermally diffusing an n-type impurity, for example, phosphorus (P) is formed on the surface of the p-type silicon substrate 101 (FIG. 3-2). Phosphorus oxychloride (POCl₃) is usually used as a diffusion source of phosphorus. When special designs are not provided, the n-type diffusion layer 102 is formed on the entire surface of the p-type silicon substrate 101. A sheet resistance of the n-type diffusion layer 102 is controlled to be about dozens of Ω/□. A depth of the n-type diffusion layer 102 is controlled to be, for example, about 0.3 to 0.5 micrometer.

Next, a resist is applied to the main surface of the p-type silicon substrate 101 that becomes the light receiving surface for protection and then the n-type diffusion layer 102 formed on other surfaces of the p-type silicon substrate 101 is removed by etching so that the n-type diffusion layer 102 remains only on one main surface protected by the resist. The resist is then removed by organic solvents. Consequently, the p-type silicon substrate 101 in which the n-type diffusion layer 102 is formed only on the light receiving surface side, is obtained (FIG. 3-3). A silicon nitride film is then formed on the n-type diffusion layer 102 as the reflection preventing film 105 by a plasma CVD method (FIG. 3-4). For example, its thickness is about 70 to 90 nanometers.

Thereafter, an aluminum paste 161 and a silver paste 162 for a rear surface are printed on the rear surface of the p-type silicon substrate 101 by screen printing method and then dried successively. Incidentally, the silver paste 162 for a rear surface is formed at a position where a copper foil is connected. The aluminum paste 161 is formed on the rear surface of the p-type silicon substrate 101 other than the position where the copper foil is connected. A silver paste 151 that becomes the first electrode layer 111 of the surface electrode 110 is printed on the reflection preventing film 105 by screen printing and then dried (FIG. 3-5). A silver paste 152 that becomes the second electrode layer 112 of the surface electrode 110 is printed on the silver paste 151 by screen printing and then dried (FIG. 3-6).

FIG. 4 is an example of characteristics of silver pastes used for forming a surface electrode. As shown in FIG. 4, the silver paste 151 used for forming the first electrode layer 111 on the n-type diffusion layer 102 has an excellent electrical contact characteristic with the n-type diffusion layer 102 after annealing, but has a high specific resistance. The silver paste 151 has a composition capable of melting and penetrating the reflection preventing film 105 by high speed annealing. The silver paste 152 used for forming the second electrode layer 112 on the first electrode layer 111 has a superior specific resistance as a silver electrode after annealing to that of the silver paste 151.

The device is then annealed in a near infrared furnace for several minutes to ten odd minutes with an annealing profile in which a peak temperature is 700 to 900°C. A peak temperature holding time of the annealing profile in the high speed annealing is defined as follows. The peak temperature holding time in the high speed annealing is the time period from the timing when temperature reaches (a maximum achieving temperature -10°C) while temperature is increased, through the maximum achieving temperature, to the timing when temperature reaches (a maximum achieving temperature -10°C) while temperature is decreased. This peak temperature holding time is within five seconds. By reducing the annealing time, deteriorations in the characteristics and crystallization characteristics of the p-type silicon substrate 101 can be suppressed.

By this annealing, aluminum is diffused as an impurity from the aluminum paste 161 into the p-type silicon substrate 101 during annealing and the p+ layer 103 that contains aluminum with high density is thus formed on the rear surface side. The p+ layer 103 is generally referred to as BSF (Back Surface Field) layer and contributes to an improvement in energy conversion efficiency of solar cells. The dried aluminum paste 161 becomes the rear-surface collecting electrode 121 after annealing. In addition, the silver paste 162 for a rear surface is also annealed simultaneously to become the rear-surface lead-out electrode 122. During this annealing, a boundary between the rear-surface collecting electrode 121 and the rear-surface lead-out electrode 122 is in an alloy state and they are electrically connected together.

Meanwhile, the silver paste for a surface melts and penetrates the reflection preventing film 105 during annealing to become the surface electrode 110 that can electrically contact the n-type diffusion layer 102. FIG. 5-1 depicts a fill factor (F.F.) of a photovoltaic device when the silver paste 151 is used. FIG. 5-2 depicts a fill factor (F.F.) of a photovoltaic device when the silver paste 152 is used. In the annealing conditions described above, while the silver paste 151 shown in FIG. 4 has a relatively large specific resistance as an electrode, such as 6.2 µΩ·cm, its electrical contact characteristic with the n-type diffusion layer 102 is excellent and a fill factor (0.777) is provided as shown in FIG. 5-1. While the silver paste 152 shown in FIG. 4 has a smaller specific resistance as an electrode than that of the silver paste 151 such as 2.5 µΩ·cm, the electrical contact characteristic with the n-type diffusion layer 102 is inferior and a fill factor (0.343) is provided as shown in FIG. 5-2, and characteristics of a solar cell are thus inferior.

Accordingly, by combining the silver pastes 151 and 152 so that the silver paste 151 functions to obtain an excellent electrical contact characteristic with the n-type diffusion layer 102 and the silver paste 152 functions to reduce the specific resistance of the surface electrode 110 for realizing thin electrodes; the surface electrode 110 that has an excellent electrical contact characteristic with the n-type diffusion layer 102 under high speed annealing conditions and has a specific resistance sufficient for realizing thin electrodes can be formed. Therefore, the photovoltaic device with the construction shown in FIGS. 1 and 2 can thus be obtained.

Both a mask pattern used in first printing for forming the surface silver electrode with the construction described above; and a mask pattern used in second printing and subsequent printing, are described next. FIG. 6-1 is an example of a top view of a mask pattern used for printing the first electrode layer, and FIG. 6-2 is an example of a top view of a mask pattern used for printing the second electrode layer.

To print the silver paste 151 that has an excellent electrical contact characteristic with the n-type diffusion layer 102; a mask pattern 200 shown in FIG. 6-1 that can form a grid-electrode forming portion 201 and a bus-electrode forming portion 202 at the same time, is used. On the other hand, to carry out the second printing the silver paste 152 with excellent conductivity; a mask pattern 210 shown in FIG. 6-2 that does not have the bus-electrode forming portion 202 and only has the grid-electrode forming portion 201 is used. By using the mask pattern 210 shown in FIG. 6-2, the printing of the bus-electrode forming portion 202 is not performed in the second printing and subsequent printing. Therefore an amount of silver paste used can be reduced greatly.

Incidentally, a tab electrode obtained by dipping solder in a copper foil, is soldered to substantially all the bus-electrode forming portion 202 in a longitudinal direction of the bus electrode 132, at a subsequent assembly process. When the cross section of a copper foil is determined as a width of 2 millimeters and a thickness of 160 micrometers, the cross section of a silver electrode formed by the first printing is, for example, a width of 2 millimeters and a thickness of 10 micrometers. When sufficient soldering is performed, the collected current flows not in the second electrode layer 112 but in the copper foil (the tab electrode). Accordingly, it suffices that the bus electrode 132 is soldered to the entire surface of the tab electrode and electrically contacts the tab electrode. Therefore, problems do not occur when the thickness of the bus-electrode forming portion 202 is reduced, as described above.

While the above explanations have described a case that the surface electrode 110 is constituted by the first and second electrode layers 111 and 112, the present invention is not limited to this case and the surface electrode can be constituted by three or more electrode layers. While the above explanations have described a case that the second electrode layer and subsequent electrode layers are formed by screen printing, they can be also formed by film forming methods such as sputtering. Incidentally, in this case, after the first electrode layer 111 is printed and annealed, the second electrode layer 112 is formed using thin film forming techniques.

According to the first embodiment, the silver paste 151 with an excellent electrical contact characteristic with the n-type diffusion layer 102 is formed on the n-type diffusion layer 102, then the silver paste 152 whose specific resistance is smaller than that of the silver paste 151 is formed thereon after annealing of the silver paste 151, and thereafter the silver pastes are high speed annealed. By this high speed annealing, the surface electrode 110 that includes both the first electrode layer 111 that melts and penetrates the reflection preventing film 105 to have an excellent contact characteristic with the n-type diffusion layer 102; and the second electrode layer 112 that can transport collected carriers with reduced loss, can be obtained. Therefore, even when high speed annealing is performed, the specific resistance of the surface electrode 110 (the grid electrode 131) can be reduced and the surface electrode can be made thin. That is, without reducing the quality of crystals, the area of electrode is reduced to increase the aperture ratio at the surface side, and thus high efficiency of the photovoltaic device is realized.

### Second Embodiment.

FIG. 7 is an example of a mask pattern used in second printing and subsequent printing according to a second embodiment of the present invention. As described in the first embodiment, in the first printing, the pattern of the bus electrode 132 and the grid electrode 131 is formed by using both the silver paste 151 with an excellent electrical contact characteristic with the n-type diffusion layer 102 after annealing; and the mask pattern 200 shown in FIG. 6-1. In the second printing, the pattern of the grid electrode 131 is formed by using both the silver paste 152 with a superior specific resistance to that of the silver paste 151 after annealing; and a mask pattern 210A in which the grid-electrode forming portion 201 is shorter than that of the mask pattern 210 shown in FIG. 6-2 in a direction where the grid-electrode forming portion 201 extends.

The silver paste 152 that is printed and dried in the second time and becomes an electrode with an excellent specific resistance after annealing, is not formed on the entire surface of the portion printed in the first time. This is because the density of a current collected by the grid electrode 131 in which the current density of a portion away from the bus electrode 132 is lower than that of a portion adjacent to the bus electrode 132, is considered. That is, in the photovoltaic device 100, a current by electricity generation is collected from a portion farthest from the bus electrode 132 (e.g. an end or a central portion) toward the bus electrode 132 through the grid electrode 131. Accordingly, the current flows most intensively, in the grid electrode 131, in a base portion in the vicinity of the bus electrode 132. Then in the base portion of the bus electrode 132, as described in the first embodiment, the silver paste 151 that becomes the first electrode layer 111 with an excellent electrical contact characteristic with the n-type diffusion layer 102, is printed and dried on the n-type diffusion layer 102 side. And the silver paste 152 that becomes the second electrode layer 112 whose specific resistance is superior to that of the first electrode layer 111 after annealing is printed and dried on the silver paste 151. In addition, only the silver paste 151 with an excellent electrical contact characteristic with the n-type diffusion layer 102, is printed and dried on the portion farthest from the bus electrode 132. Incidentally, according to the example of FIG. 7, it is shown that a case in which a grid-electrode forming portion 211A for forming the grid electrode 131 with a length of about 2/3 of a length from the bus electrode 132 to an end of the grid electrode 131, is formed from the bus-electrode forming portion (202 in FIG. 6-1). That is, the grid-electrode forming portion 211A is not formed near ends 221 in a direction where the underlying grid electrode extends.

FIG. 8 is another example of the mask pattern used in the second printing and subsequent printing according to the second embodiment of the present invention. In a case of FIG. 8, it is shown that a mask pattern 210B which has a length of about 2/3 of a half of a distance between the adjacent bus electrodes 132, can be formed from the bus electrode 132, in the grid electrode 131 between adjacent bus electrodes 132 in the case of FIG. 7. That is, according to the mask pattern 210B, a grid-electrode forming portion 211B is not formed around the ends 221 and a central portion 222 in the direction where the grid electrode 131 extends.

According to the second embodiment, the grid electrode 131 with a length of about 2/3 of the length from the bus electrode 132 to a peripheral portion of the p-type silicon substrate 101 or to an intermediate point between two adjacent bus electrodes 132. Therefore, an amount of the silver paste 152 used for forming the grid electrode 131 (the second electrode layer 112) can be reduced greatly as compared to the first embodiment. Even when printing misalignment occurs, an increase in line width can be suppressed as compared to conventional cases.

While the above explanations have described a case that the n-type diffusion layer 102 is formed on the p-type silicon substrate 101, the present invention can be also applied to a case that their conductive types are reversed. The present invention can be also applied to any kind of semiconductor substrates, as well as a silicon substrate.

### INDUSTRIAL APPLICABILITY

As described above, the manufacturing method of a photovoltaic device according to the present invention is useful for solar cells that generate electric power by utilizing sunlight.

## Claims

1. A photovoltaic device comprising:
a semiconductor substrate of a first conductive type;
a first diffusion layer that an impurity of a second conductive type is diffused in a light incident surface side of the semiconductor substrate;
a surface electrode formed on the first diffusion layer;
a second diffusion layer of the first conductive type formed on a rear surface of the semiconductor substrate opposing the light incident surface; and
a rear surface electrode formed at a predetermined position on the second diffusion layer, wherein
the surface electrode comprising:
a first electrode layer formed on the first diffusion layer; and
a second electrode layer that is formed on the first electrode layer, has a smaller specific resistance than that of the first electrode layer, and includes one or more layers.

2. The photovoltaic device according to claim 1, wherein a contact resistance of the first electrode layer with the first diffusion layer is smaller than a contact resistance between the second electrode layer and the first diffusion layer.

3. The photovoltaic device according to claim 1, wherein
the surface electrode comprising:
a plurality of grid electrodes formed in parallel on the first diffusion layer in a first direction at a first distance therebetween; and
a bus electrode whose width is wider than that of the grid electrode and that is formed in a second direction substantially perpendicular to the first direction, to connect between the grid electrodes, wherein
a length from the bus electrode to an end of the grid electrode in a direction the grid electrode extends in the second electrode layer that configures the grid electrode, is shorter than a length from the bus electrode to an end of the grid electrode in the direction the grid electrode extends in the first electrode layer.

4. The photovoltaic device according to claim 3, wherein a plurality of the bus electrodes is provided, and the second electrode layer that constitutes the grid electrode is not formed near a center between adjacent ones of the bus electrodes on the first electrode layer.

5. A manufacturing method of a photovoltaic device comprising:
a step of diffusing an impurity of a second conductive type in a light incident surface side of a semiconductor substrate of a first conductive type, to form a diffusion layer;
a step of forming a reflection preventing film that prevents reflection of light that enters the diffusion layer;
a step of printing a first paste for a surface electrode on the reflection preventing film by screen printing method;
a step of forming a second paste for a surface electrode by screen printing method, whose specific resistance is smaller than that of the first paste for the surface electrode after annealing, on the first paste for the surface electrode; and
a step of annealing the first and second pastes for the surface electrodes by high speed annealing in which a peak temperature holding time is within five seconds.

6. The manufacturing method of a photovoltaic device according to claim 5, wherein the step of forming the second paste for the surface electrode is performed for plural times until a thickness of the first and second pastes for surface electrodes becomes a predetermined thickness.

7. The manufacturing method of a photovoltaic device according to claim 5, wherein at the step of forming the first paste for the surface electrode, a contact resistance of the first paste for the surface electrode after annealing with respect to the semiconductor substrate is smaller than that of the second paste for the surface electrode.

8. The manufacturing method of a photovoltaic device according to claim 5, wherein
at the step of forming the first paste for the surface electrode, printing is performed by using a first mask pattern that includes; a grid-electrode forming portion in which a plurality of grid electrodes arranged in parallel in a first direction is formed; and a bus-electrode forming portion that connects between the grid electrodes and forms a bus electrode which is wider than the grid electrode, and
at the step of forming the second paste for the surface electrode, printing is performed by using a second mask pattern that includes only a grid-electrode forming portion.

9. The manufacturing method of a photovoltaic device according to claim 8, wherein a length of the second mask pattern from the bus-electrode forming portion to an end of grid-electrode forming portion in a direction the grid-electrode forming portion extends, is shorter than a length of the first mask pattern from the bus-electrode forming portion to an end of the grid-electrode forming portion in a direction the grid-electrode forming portion extends.

10. The manufacturing method of a photovoltaic device according to claim 9, wherein
a plurality of the bus-electrode forming portions is provided, and
the grid-electrode forming portion is not formed near a center between adjacent ones of the bus-electrode forming portions, on the second mask pattern.

11. A manufacturing method of a photovoltaic device comprising:
a step of diffusing an impurity of a second conductive type in a light incident surface side of a semiconductor substrate of a first conductive type, to form a diffusion layer;
a step of forming a reflection preventing film that prevents reflection of light that enters the diffusion layer;
a step of printing a paste for a surface electrode on the reflection preventing film by screen printing method;
a step of annealing the paste for a surface electrode by high speed annealing in which a peak temperature holding time is within five seconds, to form a first electrode layer; and
a step of forming a second electrode layer whose specific resistance is smaller than that of the first electrode layer on the first electrode layer by a thin film forming technique.
